(19)

**Europäisches Patentamt**
**European Patent Office**
**Office européen des brevets**

(11) **EP 4 755 637 A1**

(12) **EUROPEAN PATENT APPLICATION**
published in accordance with Art. 153(4) EPC

(43) Date of publication:
**10.06.2026   Bulletin 2026/24**

(51) International Patent Classification (IPC):
***B41F 33/16*** *(2006.01)*

(21) Application number: **24849304.1**

(52) Cooperative Patent Classification (CPC):
**B41F 33/16**

(22) Date of filing: **02.08.2024**

(86) International application number:
**PCT/JP2024/027815**

(87) International publication number:
**WO 2025/028659 (06.02.2025 Gazette 2025/06)**

(84) Designated Contracting States:
**AL AT BE BG CH CY CZ DE DK EE ES FI FR GB
GR HR HU IE IS IT LI LT LU LV MC ME MK MT NL
NO PL PT RO RS SE SI SK SM TR**
Designated Extension States:
**BA**
Designated Validation States:
**GE KH MA MD TN**

(30) Priority:   **02.08.2023   JP 2023126397**

(71) Applicant: **Asahi Kasei Kabushiki Kaisha
Tokyo 100-0006 (JP)**

(72) Inventors:
• **FURUKAWA, Masashi
Tokyo 100-0006 (JP)**

• **KIMURA, Ippei
Tokyo 100-0006 (JP)**
• **FUJIKI, Yuzo
Tokyo 100-0006 (JP)**
• **NAKAMURA, Akinao
Tokyo 100-0006 (JP)**
• **YAMAGUCHI, Misuzu
Tokyo 100-0006 (JP)**
• **MATSUURA, Hiroki
Tokyo 100-0006 (JP)**

(74) Representative: **D Young & Co LLP
3 Noble Street
London EC2V 7BQ (GB)**

(54)   **PLANNING ASSISTANCE DEVICE, INFORMATION PROCESSING METHOD, AND PROGRAM**

(57)   A formulation support device including: an image generation unit configured to predict, based on a image to be printed, a plate-making condition of a printing plate, and a printing condition, dots of each color in printed matter obtained by printing the image to be printed based on the plate-making condition and the printing condition, and to generate predicted image for each color represented by the dots; and an image composition unit configured to synthesize a composite predicted image based on a plurality of the predicted image for each colors.

Figure 5B

```
        ( Step8 )
            │
            ▼
┌──────────────────────────────────────────────┐  S11
│ RECEIVE CORRECTION INFORMATION OF PREDICTED   │
│ IMAGE FOR EACH COLOR FOR EACH COLOR IN        │
│ RESPONSE TO USER'S OPERATION                  │
└──────────────────────────────────────────────┘
            │
            ▼
┌──────────────────────────────────────────────┐  S12
│ GENERATE CORRECTED PREDICTED IMAGE FOR EACH   │
│ COLOR BASED ON CORRECTION INFORMATION         │
└──────────────────────────────────────────────┘
            │
            ▼
┌──────────────────────────────────────────────┐  S13
│ SYNTHESIZE COMPOSITE PREDICTED IMAGE BASED    │
│ ON PLURALITY OF CORRECTED RESPECTIVE COLOR    │
│ PREDICTION IMAGES                             │
└──────────────────────────────────────────────┘
            │
            ▼
┌──────────────────────────────────────────────┐  S14
│ PERFORM DISPLAY CONTROL WHILE COMPARING       │
│ COMPOSITE PREDICTED IMAGE WITH IMAGE TO BE    │
│ PRINTED                                       │
└──────────────────────────────────────────────┘
            │
            ▼
        ( Step 7 )
```

**EP 4 755 637 A1**

## Description

## Technical Field

The present invention relates to a formulation support device, an information processing method, and a program.

## Background Art

For example, Patent Literature 1 discloses a printing system that can easily grasp a plate-making condition and a printing condition for obtaining high-quality printed matter in flexographic printing.

## Citation List

## Patent Literature

Patent Literature 1: Japanese Patent Laid-Open No. 2016-049768

## Summary of Invention

## Technical Problem

However, in the printing system disclosed in Patent Literature 1, it is necessary to actually print an original image by a printing unit, and measure a characteristic of the original image from an evaluation region of the original image. Thus, condition adjustment is performed in the same way as conventional condition adjustment such that printing is actually performed multiple times until a desired plate-making condition and printing condition are determined.
The present invention has been made in view of the problem described above, and aims at providing a formulation support device, an information processing method using the device, and a program with which an appropriate predicted image for each color and composite predicted image can be obtained without performing a printing step.

## Solution to Problem

[1] A formulation support device including:

an image generation unit configured to predict, based on a image to be printed, a plate-making condition of a printing plate, and a printing condition, dots of each color in printed matter obtained by printing the image to be printed based on the plate-making condition and the printing condition, and to generate predicted image for each color represented by the dots; and

an image composition unit configured to synthesize a composite predicted image based on a plurality of the predicted image for each colors.

[2] The formulation support device according to [1], further including:

a prediction unit configured to output correction information for correcting each dot included in the image to be printed based on the plate-making condition and the printing condition, wherein

the image generation unit generates predicted image for each color represented by corrected dots by correcting the dots of the image to be printed based on the correction information.

[3] The formulation support device according to [2], wherein
the correction information is at least one of formability, size, and shape.

[4] The formulation support device according to any one of [1] to [3], wherein

a closed region formed by adjacent ones of the plurality of dots being in contact with each other is recognized as a void dot, and

the image generation unit generates the predicted image for each color by correcting the void dot included in the image to be printed based on the plate-making condition of the printing plate and the printing condition, and by generating a corrected void dot.

[5] The formulation support device according to [4], wherein
correction information for correcting the void dot based on the plate-making condition and the printing condition is at least one of formability, size, and shape.

[6] The formulation support device according to any one of [1] to [5], further including:
a display control unit configured to display the composite predicted image and the image to be printed to be comparable with each other.

[7] The formulation support device according to any one of [1] to [6], further including:
a display control unit configured to perform display control on the plate-making condition and/or the printing condition related to the composite predicted image.

[8] The formulation support device according to any one of [1] to [7], further including:
a condition generation unit configured to change the plate-making condition and/or the printing condition when information about the dots in the predicted image for each color does not satisfy a predetermined condition.

[9] The formulation support device according to any one of [1] to [8], further including:

a correction unit configured to receive correction of the predicted image for each color in response to a user's operation, wherein

the image generation unit generates a corrected predicted image for each color based on the correction, and

the image composition unit synthesizes a corrected composite predicted image based on the corrected predicted image for each color.

[10] An information processing method, performed by a formulation support device, including:

an image generation step of predicting, based on a image to be printed, a plate-making condition of a printing plate, and a printing condition, dots of each color in printed matter obtained by printing the image to be printed based on the plate-making condition and the printing condition, and of generating predicted image for each color represented by the dots; and

an image composition step of compositing a composite predicted image based on a plurality of the predicted image for each colors.

[11] A program that causes a formulation support device to perform:

an image generation step of predicting, based on a image to be printed, a plate-making condition of a printing plate, and a printing condition, dots of each color in printed matter obtained by printing the image to be printed based on the plate-making condition and the printing condition, and of generating predicted image for each color represented by the dots; and

an image composition step of compositing a composite predicted image based on a plurality of the predicted image for each colors.

**Advantageous Effect of Invention**

The present invention can provide a formulation support device, an information processing method using the device, and a program with which an appropriate predicted image for each color and a composite predicted image can be obtained without performing a printing step.

**Brief Description of Drawings**

[Figure 1] Figure 1 is a diagram illustrating a system configuration of the present embodiment.

[Figure 2A] Figure 2A is a schematic configuration diagram of a formulation support device of the present embodiment.

[Figure 2B] Figure 2B is a schematic diagram illustrating an example of a data structure of print data.

[Figure 2C] Figure 2C is a schematic diagram illustrating an example of a prediction model.

[Figure 2D] Figure 2D is a diagram illustrating a concept of converting dots in a color separation image into corrected dots in predicted image for each color.

[Figure 2E] Figure 2E is a diagram illustrating a concept of converting void dots in a color separation image into corrected void dots in predicted image for each color.

[Figure 2F] Figure 2F is an example illustrating that the color separation image is represented by dots.

[Figure 2G] Figure 2G is an example illustrating that the predicted image for each color is represented by corrected dots.

[Figure 2H] Figure 2H is a diagram illustrating a specific example of print data related to dots.

[Figure 2I] Figure 2I is a diagram illustrating a specific example of print data related to void dots.

[Figure 2J] Figure 2J is a diagram illustrating a result of outputting information about corrected dots and corrected void dots using a prediction model.

[Figure 3A] Figure 3A is a configuration diagram illustrating a relation between a correction curve and a print curve.

[Figure 3B] Figure 3B is a schematic diagram illustrating an aspect of gradation expression in a case of beautiful fading.

[Figure 3C] Figure 3C is a schematic diagram illustrating an aspect of gradation expression having a hard edge.

[Figure 3D] Figure 3D is a schematic diagram illustrating an aspect of gradation expression in which a tone is reversed.

[Figure 3E] Figure 3E is a schematic diagram illustrating an overlap between a dot in a color separation image and a corrected dot.

[Figure 4A] Figure 4A is a schematic diagram illustrating typical steps for obtaining a composite predicted image from a image to be printed.

[Figure 4B] Figure 4B is a diagram illustrating an example of a screen displayed on a display device.

[Figure 5A] Figure 5A is a flowchart illustrating an example of processing performed by a formulation device of the present embodiment.

[Figure 5B] Figure 5B is a flowchart illustrating an example of processing performed by the formulation device of the present embodiment.

**Description of Embodiments**

The following describes an embodiment of the present invention (hereinafter, referred to as a "present embodiment") in detail. However, the present invention is not limited thereto, and can be variously modified without departing from the gist of the invention.

1. Formulation support device

In the present embodiment, a formulation support device includes: an image generation unit configured to predict, based on a image to be printed, a plate-making condition of a printing plate, and a printing condition, dots of each color in printed matter obtained by printing the image to be printed based on the plate-making condition and the printing condition, and to generate predicted image for each color represented by the dots; and an image composition unit configured to synthesize a composite predicted image based on a plurality of the predicted image for each colors.

Alternatively, the formulation support device of the present embodiment may include: an image generation unit configured to generate predicted image for each color represented by corrected dots by correcting, based on the plate-making condition of the printing plate and the printing condition, dots included in a color separation image in which the image to be printed is represented by dots of each color; and an image composition unit configured to synthesize a composite predicted image based on a plurality of the predicted image for each colors.

The present invention can be applied to offset printing, gravure printing, and flexographic printing. The following describes the present embodiment by exemplifying a case of flexographic printing. However, the present embodiment is not limited thereto, and can be similarly applied to offset printing and gravure printing.

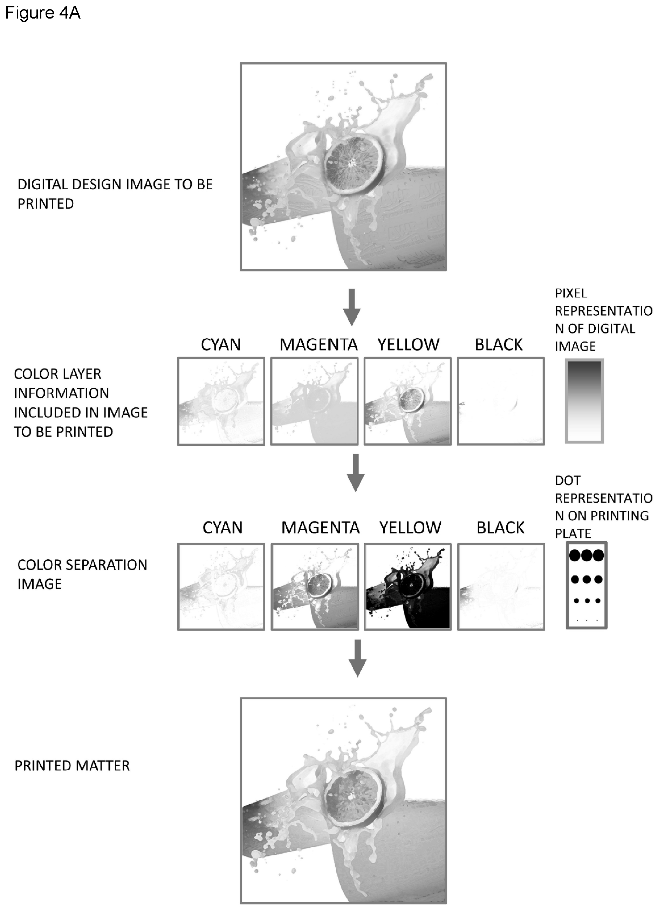

Figure 4A shows a schematic diagram illustrating typical steps for obtaining the composite predicted image from the image to be printed. As shown in Figure 4A, in a conventional flexographic printing process, before performing mass printing, based on a design of a digital image called a vector image (hereinafter, also referred to as a "image to be printed") as well as color management leading to quality standards by a printing certification system conforming to the international standard ISO 12647 (for example, PSO certification by Fogra in Germany, G7 certification by Idealliance in the United States, JapanColor certification in Japan, or the like), manufacture of flexographic printing plates and printing are repeatedly performed to obtain a plate-making/printing condition that can achieve target values of color density, and a color density condition is searched for to make ink density, a concealing property, and the like favorable. Manufacture of the flexographic printing plate and printing are repeated to obtain the plate-making/printing condition for achieving a gradation property, and a gradation property condition for stably printing dots and the like is searched for.

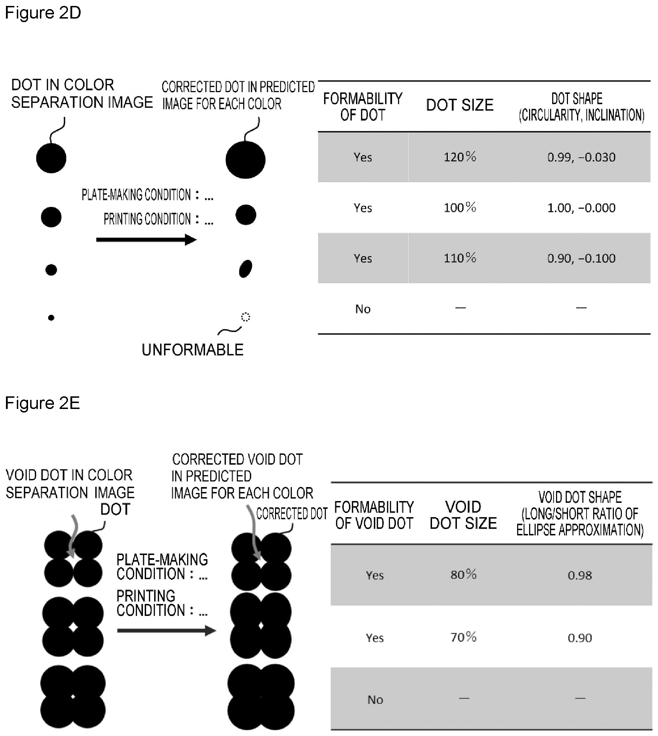

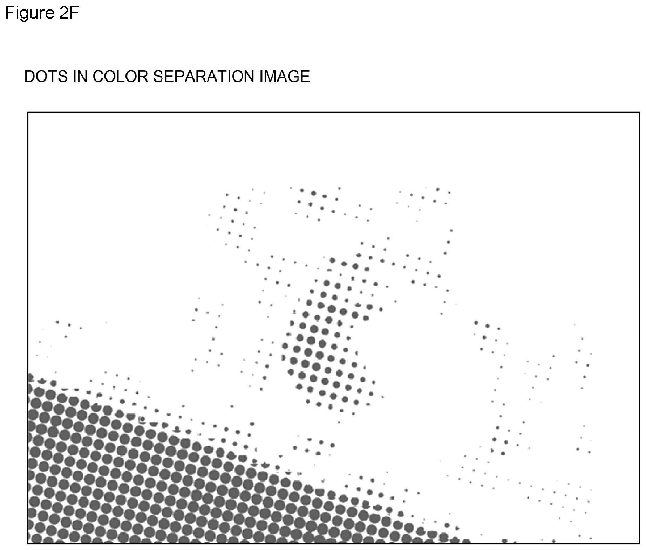

The "dots" indicate mesh-like points for representing shading of the printed matter as illustrated in Figure 2D. The dot may also be called a halftone dot. For example, in flexographic printing, when printed matter printed with C (cyan) is seen through a microscope, multiple number of small printed points are seen (refer to Figure 2F). This point is referred to as a dot, and the printed matter is represented by a collection of dots. Typically, a color is represented to be lighter as the dot is smaller and the number of the dots per unit area is smaller, and a color is represented to be darker as the dot is larger and the number of the dots per unit area is larger. Printed matter with shading is reproduced by combining the size of the dot and the number of the dots per unit area. In a case of reproducing gradation of a photograph, a pattern (monochrome/color), and the like by printing, shading may be represented by a ratio between a white portion of paper to be subjected to printing, and the size of the dot and the number of the dots per unit area.

As information about dots, exemplified are "screen ruling" indicating the number of dots present within 1-inch width, "circularity" or "inclination" indicating the shape of a dot, "size" for representing shading, and "angle" related to occurrence of moire.

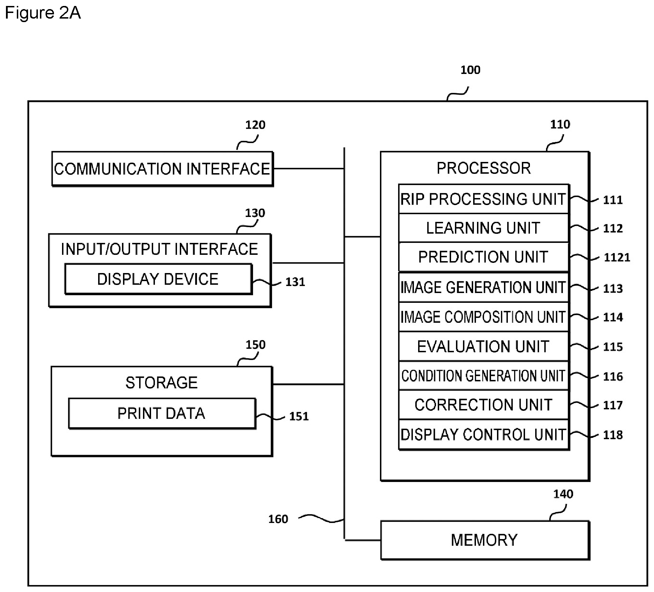

In addition, "void dot" means, as illustrated in Figure 2E, a closed region formed by a plurality of adjacent dots being in contact with each other. As information about void dots, exemplified are "screen ruling" indicating the number of void dots present within 1-inch width, "long/short ratio" obtained when approximating a void dot to an ellipse, and "size" for representing shading.

In a search process for the above color density condition and gradation condition performed in a conventional flexographic printing process, a test pattern appropriate for evaluating each condition is used instead of a digital image as a print target. An appropriate plate-making condition and printing condition are searched for by creating a flexographic printing plate on which a test pattern is formed under various plate-making conditions, and performing printing with the obtained flexographic printing plate under various printing conditions. This makes it possible to search for the plate-making condition and the printing condition suitable for ink, plate-making equipment, and printing equipment to be used.

Subsequently, as illustrated in Figure 4A, a vector image of a digital design has color layer information for each ink color, such as cyan, magenta, yellow, and black, for example. Herein, the vector image of the digital design means an image format that expresses two-dimensional information such as an image or a character by converting a plurality of points into numerical values and using curves derived by numerical expressions.

The pixel representation of a digital image and a representation expressed by projections and depressions of a printing plate are different. Thus, as illustrated in Figure 4A, RIP processing is performed on the vector image having pieces of the color layer information, color density and a dot size are determined for each color, and a raster image for each color is created. That is, in this process, a conversion is made to configure an image with pixels in accordance with a form of representing two-dimensional information such as an image or a character by dots of projections and depressions of the printing plate, instead of a state in which the two-dimensional information is represented by curves derived by numerical expressions in the digital image. In the present embodiment, the vector image is described as the image to be printed, but the raster image described above can also be used as the image to be printed in other embodiments.

As illustrated in Figure 4A, the raster image for each color is created for each ink color to be used, such as cyan, magenta, yellow, and black. Thus, even when the vector image is the same, the raster image for each color is generated in accordance with an ink set to be used. For example, when four colors of ink are used, four raster images for the respective colors are created, and when seven colors of ink are used, seven raster images for the respective colors are created. In the present embodiment, information about the raster image for each color corresponding to each color is also referred to as a "color separation image".

The raster image for each color serves as data for creating a flexographic printing plate for each color. That is, to enable printing of a dot representation expressed by the raster image for each color, projections and depressions of the flexographic printing plate is formed in a plate-making process.

Flexographic printing plates for respective ink colors are then produced based on the raster images for the respective colors, and multicolored printing is performed using these flexographic printing plates to obtain printed matter (Figure 4A). Also in this case, the flexographic printing plates for the respective ink colors are produced based on the raster images for the respective colors, and a multicolored-printing test is performed using these flexographic printing plates to determine conditions under which printing can be performed with good reproducibility. For example, even if the flexographic printing plate is produced based on the raster image for each color, dots exactly the same as those in the raster image for each color cannot be represented on a recording medium due to pressing force, ink characteristics, and the like. Specifically, dots actually fewer than those in the raster image for each color may be transferred onto the recording medium. In such a case, the raster image for each color is corrected such that dots are made larger overall or a method of arranging the dots is changed. The multicolored-printing test is then performed again, and a condition under which printing can be performed with good reproducibility is searched for.

Through the above processes, in the conventional flexographic printing process, the flexographic printing plate that enables mass printing and the printing condition therefor are determined. Decision of the plate-making condition and the printing condition often depends on an expert, and a plurality of times of tests are required to determine the conditions, so that the entire process described above may take one or more years.

One of reasons why such a test is required is that the printing plate is pressed against a printing base material at the time of printing, so that the dots are deformed. For example, when printing is performed by using a printing plate having projections and depressions corresponding to the dots, the projections and depressions are deformed due to the printing condition, and sizes and shapes of the dots to be printed are somewhat different from the projections and depressions of the printing plate. Such a phenomenon may occur particularly when the printing plate is made of resin such as rubber.

Thus, in the processes described above, the formulation support device of the present embodiment predicts in advance predicted image for each colors represented by corrected dots obtained by correcting, based on the plate-making condition of the printing plate and the printing condition, dots of a color separation image (raster image) in which a image to be printed is represented by dots of each color, the corrected dots being obtained when printing is performed under the printing condition by using the printing plate produced under a predetermined plate-making condition, and obtains a composite predicted image by compositing the predicted image for each colors based thereon.

At this time, when a relation between information about the dots in the color separation image and information about the corrected dots in the predicted image for each color does not satisfy a predetermined target index, the plate-making condition and/or the printing condition may be changed, the same processing may be repeated, and an optimum solution of the predicted image for each color for each color may be searched for.

Furthermore, when reproducibility between the composite predicted image and the image to be printed is evaluated and the reproducibility is high, that is, when it is determined that the image to be printed can be printed with good reproducibility, any one of the plate-making condition, the printing condition, and the color separation image for each color obtained through the search is output as recommendation information. On the other hand, when the reproducibility between the composite predicted image and the image to be printed is evaluated and the reproducibility is low, that is, when it is determined that the image to be printed is not reproduced, the plate-making condition and/or the printing condition may be changed, a new color separation image for each color may be newly generated, the same processing may be repeated, and an optimum solution of the predicted image for each color for each color may be searched for.

With the formulation support device of the present embodiment, a desired predicted image for each color or composite predicted image can be obtained without performing the printing step, and a processing load of the information processing device can be obviously reduced as compared with a method of directly physically calculating a deformation phenomenon of the projections and depressions on the printing base material based on the shape and hardness of the printing plate, an ink amount, and pressing force, and calculating the size of the dot based on a deformation amount thereof, as an information processing method.

The following describes a configuration of the formulation support device of the present embodiment in detail.

1.1. Hardware configuration

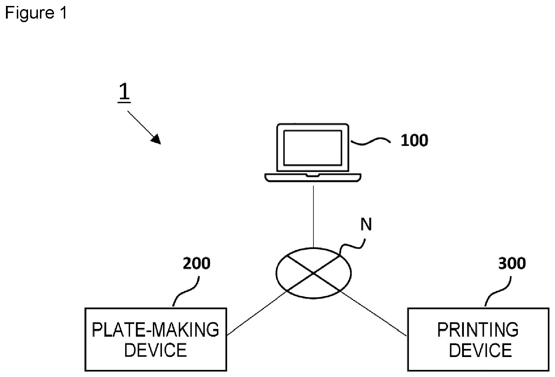

Figure 1 illustrates an example of the present system. The present system is a formulation support system that indicates recommendation information of raster images for respective colors. A formulation support device 100 of the present embodiment may be connected to a plate-making device 200 and a printing device 300 via a network. In the present embodiment, the plate-making device 200 may be a manufacturing device for a flexographic printing plate, and the printing device 300 may be a printing machine that executes a flexographic printing method. As the plate-making device 200 and the printing device 300, well-known conventional devices can be used.

Figure 2A illustrates a schematic configuration diagram of the formulation support device 100 of the present embodiment. The formulation support device of the present embodiment may be a general-purpose computer such as a personal computer and a server. As illustrated in Figure 2A, the formulation support device 100 includes, for example, a processor 110, a communication interface 120, an input/output interface 130, a memory 140, a storage 150, and one or a plurality of buses 160 for interconnecting these constituent elements.

The processor 110 is not limited to but includes, by way of example, one or a plurality of central processing units (CPU), a microprocessor (MPU), a graphics processing unit (GPU), a processor core, a multiprocessor, an Application Specific Integrated Circuit (ASIC), a Field Programmable Gate Array (FPGA), and the like, and may implement processing, functions, or methods disclosed in each embodiment by an integrated circuit (IC) chip, an LSI, or a dedicated circuit.

The communication interface 120 transmits/receives various kinds of data to/from another device via a network. This communication may be performed in any of a wired manner or a wireless manner, and any communication protocol may be used so long as the communication can be performed with each other. For example, the communication interface 120 may be implemented as hardware such as a network adapter, various kinds of software for communication, or a combination thereof.

The input/output interface 130 includes an input device to which various operations are input, and an output device that outputs a processing result and the like. For example, the input/output interface 130 may include an information input device such as a keyboard, a mouse, and a touch panel, and an information output device such as a display device 131. The formulation support device 100 may receive a predetermined input or may perform predetermined output by connecting the input/output interface 130 as an external device thereto.

For example, the formulation support device 100 may output recommended conditions for the plate-making condition and the printing condition to the plate-making device 200 and the printing device 300.

The memory 140 temporarily stores a program loaded from the storage 150, and provides a working area to the processor 110. The memory 140 also temporarily stores various kinds of data generated during a period in which the processor 110 executes the program. The memory 140 may be, for example, a high-speed random access memory such as a DRAM, an SRAM, a DDR RAM, or another random access solid-state storage device, or may be a combination thereof.

The storage 150 stores a program, functional units, and various kinds of data. The storage 150 may store print data 151, for example.

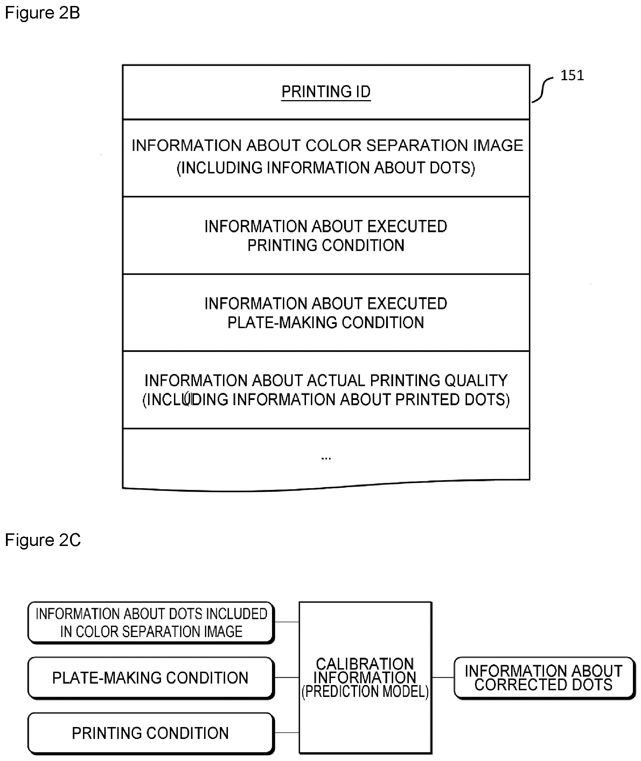

In the print data 151, recorded is data printed under a predetermined plate-making condition and printing condition based on the color separation image. Specifically, as illustrated in Figure 2B, a printing ID that can uniquely specify the printing condition, information about the color separation image to be printed, information about the plate-making condition for the flexographic printing plate used for printing the digital image, information about the printing condition for the printing plate, and information about a printed image may be recorded in association with each other. The print data 151 can be used as data for learning for various models used in the present embodiment, or data for constructing an algorithm.

The storage 150 may be, for example, one or a plurality of magnetic disc storage devices, an optical disc storage device, a flash memory device, or a nonvolatile memory such as another nonvolatile solid-state storage device, or may be a combination thereof. As another example of the storage 150, one or a plurality of storage devices disposed at a distance from the processor 110 can be exemplified.

1.2. Software configuration

The processor 110 executes processing, a function, or a method implemented by a code or a command included in the program stored in the storage 150. As illustrated in Figure 2A, the processor 110 of the present embodiment may function as a RIP processing unit 111, a learning unit 112, a prediction unit 1121, an image generation unit 113, an image composition unit 114, an evaluation unit 115, a condition generation unit 116, a correction unit 117, and a display control unit 118. The following describes each of the functional units.

The RIP processing unit 111 generates a color separation image represented by dots of each color based on the image to be printed. More specifically, the RIP processing unit 111 may perform Raster Image Processor (RIP) processing of converting a image to be printed created in a vector format or the like on a computer into a color separation image in a raster format that can be interpreted by a printing machine or a printer. The color separation image obtained in this manner is an image obtained by color-separating the image to be printed into dots of ink colors such as cyan, magenta, yellow, and black, and is an image obtained by converting continuous-tone image data into a dot pattern as illustrated in Figure 4A.

When the vector image is a photograph acquired by an imaging device including a CMOS sensor or the like, the image to be printed preliminarily has color information separated into CMYK acquired by the CMOS sensor. In this case, the image to be printed is image information in a state of having CMYK color layer information, so that these can be directly used as color-color separation images. In this manner, when the image to be printed is image information in a state of having the CMYK color layer information, color separation is not required, and the RIP processing unit 111 may perform only processing of converting continuous-tone image data of each color image into a dot pattern to obtain a color separation image.

The RIP processing unit 111 may perform color separation processing based on information about ink to be used. The color of pixels such as RGB of the image to be printed, which is a digital image, is handled as data in a state of being converted into CMYK on the vector image in advance. On that basis, it is further necessary to consider a color of a color material such as a pigment of ink to be used. Thus, even if the image to be printed is simply separated into RGB, it does not immediately indicate the color of the ink to be used. In particular, although a digital image such as a display is usually represented mainly by three colors of RGB and contrast, in a case of ink, it is common to be represented by four colors of cyan, magenta, yellow, and black, or to be represented by seven colors of ink obtained by further adding light colors such as light cyan, light magenta, and light yellow thereto, or to be represented by a composition of more colors by using special color ink such as orange, green, and violet. Thus, the RIP processing unit 111 may perform processing of color-separating the image to be printed based on the information about the color of ink acquired in advance, and may obtain a color separation image for each type of color of ink to be used.

In addition, the RIP processing unit 111 can use a rasterization step on a general computer workstation. The RIP processing unit 111 may perform processing of converting continuous-tone image data into a dot pattern based on data associating digital color density with a dot configuration of the printing plate. For example, the RIP processing unit 111 may obtain a color separation image in which the image to be printed is represented by dots of each color through the rasterization step of predicting and evaluating color density for one or a plurality of pixels of the image to be printed of each color, and converting the color density into a dot configuration of the printing plate in a manner reflecting the color density.

The learning unit 112 creates a prediction model for correcting each dot included in the color separation image when it is assumed that printing is performed under a predetermined printing condition using the flexographic printing plate manufactured under a predetermined plate-making condition.

Herein, the "prediction model" may be information for converting each dot included in the color separation image based on the predetermined plate-making condition and printing condition. For example, as illustrated in Figure 2D and Figure 2E, a prediction model for deriving a corrected dot may be exemplified, when each dot included in the color separation image is printed under a predetermined printing condition using the flexographic printing plate manufactured under a predetermined plate-making condition, the prediction model for determining whether the dot can be formed, a degree of change in the size of the dot, and distortion of the shape of the dot.

The prediction model may be related to a void dot, and may be a prediction model for deriving a void dot to be obtained, when each void dot included in the color separation image is printed under a predetermined printing condition using the flexographic printing plate manufactured under a predetermined plate-making condition, the prediction model for determining whether the void dot can be formed, a degree of change in the size of the void dot, and distortion of the shape of the void dot.

The prediction model of the present embodiment may be, as illustrated in Figure 2C, a model capable of outputting information about a corrected dot or a corrected void dot such as information about formability, size, and shape of the corrected dot or the corrected void dot, when the information about each dot or void dot included in the color separation image, the plate-making condition, and the printing condition are input.

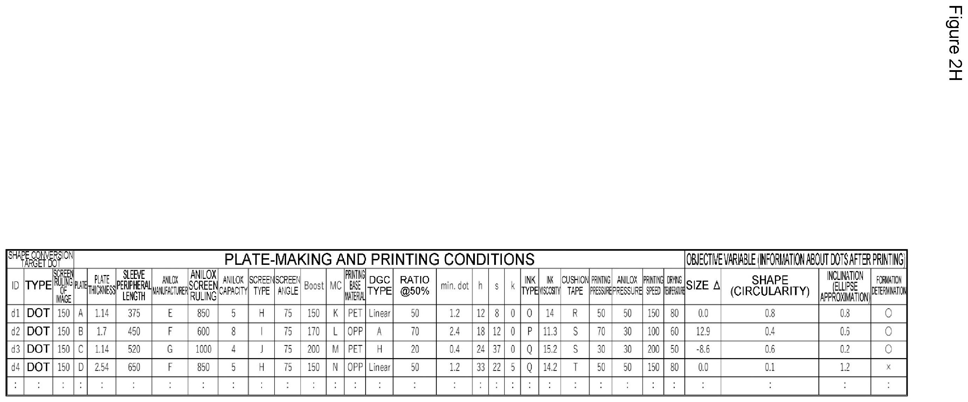

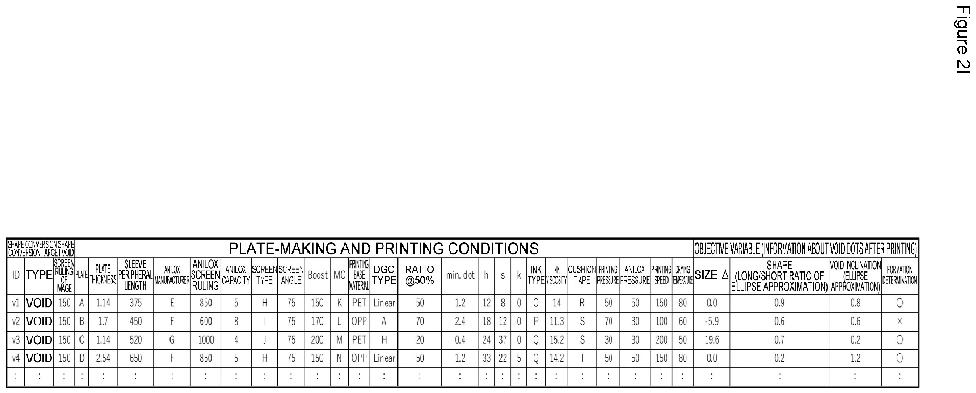

As part of print data illustrated in Figure 2B, Figure 2H illustrates a specific example of the print data associating an ID for uniquely identifying one dot in the color separation image, the plate-making condition for the printing plate, the printing condition for printed matter using the printing plate manufactured under the plate-making condition, and information about a printed dot, which is one of printing qualities. In addition, Figure 2I illustrates a specific example of the print data associating an ID for uniquely identifying one void dot in the color separation image, the plate-making condition for the printing plate, the printing condition for printed matter using the printing plate manufactured under the plate-making condition, and information about a printed void dot, which is one of printing qualities. The print data illustrated in Figure 2H and Figure 2I may be used as data for learning.

Figure 2D illustrates printing results of 4 examples due to space restrictions, but data of 3000 examples of dots and void dots is used in the present embodiment. The print data or the data for learning to be used is not limited thereto, and the number of pieces thereof may be more extensive.

In Figure 2H and Figure 2I, each abbreviation means the following. "Midpoint", "Slope at midpoint", "Minimum Dot", "highlight shape", "shadow shape", and "Keep 0% to" are incorporated in the present embodiment with reference to US 11,575,806 B2.

- MC: means a type of a microcell. The microcell means a portion in which a transferring property of the ink is increased by making a fine pattern that does not affect a design on a surface to form projections and depressions.

- ratio@50%: indicates "Midpoint".

- DGC type: indicates "Slope at midpoint".

- min.dot: indicates "Minimum Dot".

- h: indicates "highlight shape".

- s: indicates "shadow shape".

- k: indicates "Keep 0% to".

In Figure 2H and Figure 2I, regarding presence or absence of formation of a dot or a void, in test pattern printed matter including a plurality of dots having the same shape, when 50% or more of the number of dots was able be formed on the printed matter, it was defined as "good", and when less than 50% of the number of dots was able to be formed on the printed matter, it was defined as "poor". Regarding the size $\Delta$, shape, and inclination, these values were measured for each dot in the test pattern printed matter including a plurality of dots having the same shape, and average values thereof were calculated and recorded.

The prediction model illustrated in Figure 2C was created by using 3000 examples of data illustrated in Figure 2H and Figure 2I as the data for learning. Specifically, the prediction model was constructed by three methods including Partial Least Squares (PLS), Support Vector Regression (SVR), and Random Forests (RF), using the data for learning. For constructing each prediction model, a hyperparameter maximizing generalization performance was selected and used. Specifically, as an index of the generalization performance of the model, used was a determination coefficient R2 that was calculated based on a predicted value obtained by performing 5-fold cross-validation described later. For a model obtained by using all combinations of possible values of respective hyperparameters, R2 described above was calculated, and a hyperparameter with which a value of R2 became maximum was employed.

At the time of learning, part of the data may be converted into a dummy variable and the like to be subjected to machine learning. For example, for PET and OPP indicating materials of the printing base material, PET may be set as 0 and OPP may be set as 1 as dummy variables. Due to this, by converting data classified by a category instead of a numerical value into a numerical value, the model may be enabled to treat category-type data.

Prediction accuracy by each prediction model was evaluated by the determination coefficient R2. Specifically, in the 5-fold cross-validation, the data for learning was divided into five pieces, four of them were used as data for constructing a model, and a regression model was constructed by each of the models described above. The rest one of the pieces of data for learning was used, as validation data, for evaluating prediction performance of the constructed regression model. There were five ways to select the data for constructing a model, and by predicting each piece of the validation data by each model, all pieces of training data were regarded as "external data not used for constructing the model" to obtain a prediction result. Due to this, five R2 values were obtained, and an average value thereof was assumed to be an R2CV value. A final model was constructed by using all pieces of the training data and the determined hyperparameter.

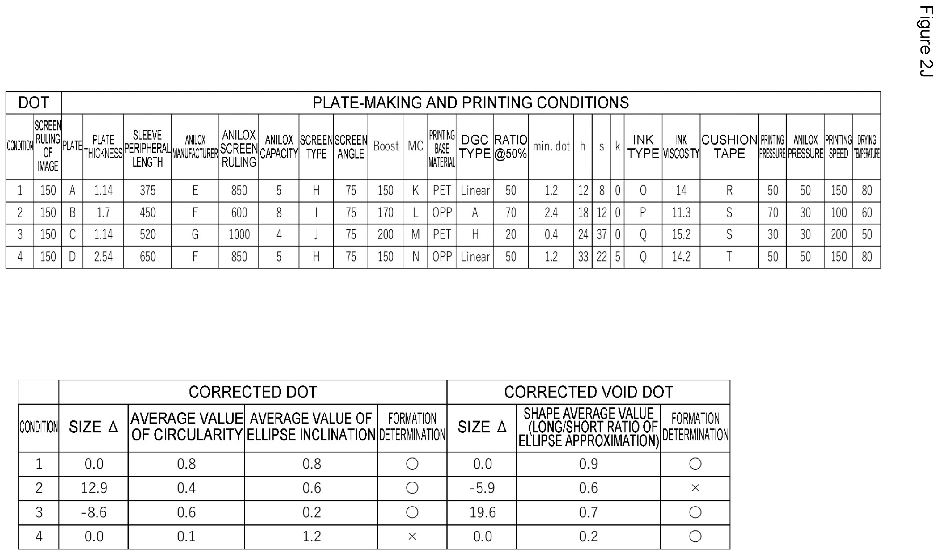

Figure 2J illustrates an output result obtained by receiving a predetermined plate-making condition and printing condition as inputs and determining, regarding dots and void dots in the color separation image, size, shape, and formability of corrected dots and corrected void dots obtained at this point, by using the prediction model obtained as described above.

As described above, it has been demonstrated that the prediction model can be constructed, the prediction model being capable of outputting information about a corrected dot or a corrected void dot estimated to be formed in the printed matter, based on the information about dots or void dots in the color separation image, plate-making condition information indicating the plate-making condition for the printing plate, and printing condition information indicating the printing condition for obtaining the printed matter using the printing plate manufactured under the plate-making condition. In addition, it has been demonstrated that the prediction model has predetermined accuracy, and can output appropriate information about corrected dots or corrected void dots without performing the printing step.

It has been also found that it is unnecessary to directly predict a deformation phenomenon of projections and depressions on the printing base material in the prediction, and determination is made while considering the deformation phenomenon of the projections and depressions on the printing base material by considering the plate-making condition information that affects the shape, hardness, and the like of the printing plate, and the printing condition information that affects the ink amount, pressing intensity, and the like, so that it is possible to predict information about the corrected dots or the corrected void dots.

The specific examples illustrated in Figure 2H to Figure 2J are merely examples for indicating technical significance of the formulation support device of the present embodiment, and the present embodiment is not limited to the specific examples in Figure 2H to Figure 2J.

For example, as the prediction model, although there is no particular limitation, it is possible to employ a model using multiple regression analysis, ridge regression, partial least squares regression, a multilayer perceptron, a neural network such as a Convolutional Neural Network (CNN) and a Recurrent Neural Network (RNN), a support vector machine using an optional kernel function such as a Gaussian kernel, a random forest modeled as a regression tree, a hidden Markov model, and the like, and various other models such as a statistical model and a stochastic model. It is also possible to employ a model that makes comprehensive determination by combining various models. Additionally, in a case of a qualitative variable, various discrimination and analysis methods such as logistic regression, a random forest, and a neural network may be used.

The following further describes information about the plate-making condition, information about the printing condition, and information about the printing quality. The following describes an aspect of the information about the plate-making condition, the information about the printing condition, and the information about the printing quality, but the information about the plate-making condition, the information about the printing condition, and the information about the printing quality are not limited thereto.

First, a plate-making method for the flexographic printing plate in the plate-making device 200 is not particularly limited, but a method for emitting radiation to a printing original plate to perform pattern engraving processing is exemplified. Back exposure or surface exposure may be performed before or after the engraving processing, or development may be performed after the engraving processing. The plate-making method for the flexographic printing plate may be different depending on a type of the printing original plate.

The radiation used for pattern formation of the printing plate may be appropriately selected in accordance with a configuration of the printing original plate. Such radiation is not particularly limited, but may be laser light, ultraviolet rays, infrared rays, visible rays, X-rays, an electron beam, and the like, for example. For example, laser light may be emitted to the printing original plate to perform pattern engraving processing. If the printing original plate has an infrared ablation layer, infrared rays may be emitted thereto to perform pattern engraving processing. In this case, the infrared ablation layer serves as a mask image at the time of being exposed and cured. When an unexposed part of a photosensitive resin composition layer is washed out after the exposure is ended, the infrared ablation layer may also be removed at the same time.

The plate-making condition information for such a flexographic printing plate is not particularly limited but includes a condition for manufacturing the flexographic printing plate from a flexographic printing original plate, and examples thereof include a type of an original plate, a type of a microcell, information about radiation, a correction curve, screen ruling of an image, a type of a screen, an angle of a screen, and the like.

Although there is no particular limitation, information about a type of an original plate, a type of a microcell, and radiation may be mainly the plate-making condition related to color density or a concealing property, and a correction curve, screen ruling of an image, a type of a screen, an angle of a screen, and the like may be mainly the plate-making condition related to gradation expression.

As the information about radiation, intensity of radiation and the like are exemplified. An uneven shape of engraving is changed corresponding to the intensity of radiation and the like, and color density or a concealing property of the printed matter obtained by using the flexographic printing plate may be changed. Appropriate information about the radiation is preferably set while considering the printing condition such as a contact pressure between an anilox roll and a plate cylinder, and a contact pressure between the printing base material and the plate cylinder in addition to the plate-making condition such as a type of an original plate and a type of a microcell.

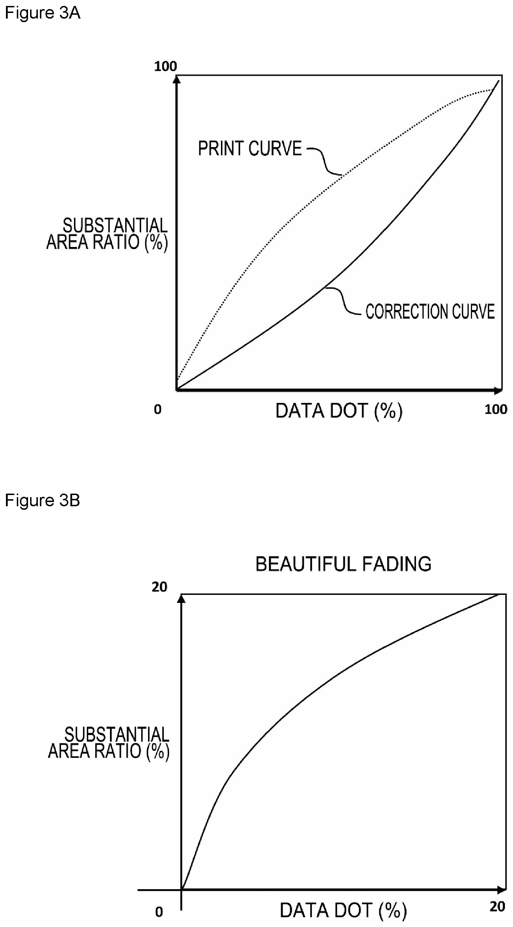

The correction curve is a curve indicating a relation between ink density and a pixel area ratio per unit area (hereinafter, "data dot%") in raster image data of the flexographic printing plate based on a print curve. Figure 3A illustrates a relation between the correction curve and the print curve. The flexographic printing plate has elasticity, so that a contact area between the printing base material and the plate cylinder is increased corresponding to a printing pressure. Thus, actual ink density tends to be higher than ink density that is estimated from an area of an outermost surface of the flexographic printing plate. Thus, from a viewpoint of making the flexographic printing plate to obtain a desired image when the contact area between the printing base material and the plate cylinder is increased due to the printing pressure, it is preferable to create the correction curve while considering an increase of the contact area based on the print curve representing a relation between the actual ink density and the data dot%.

By way of example, a standardized print curve is specified in ISO 12647-2 and the like, and a dot size and the like of the plate may be corrected to adjust the print curve obtained under a predetermined printing condition to match such a standardized curve. For this correction, the correction curve is used. For example, flexographic printing is a printing process for performing printing on all types of soft and hard base materials such as plastic, paper, a carton, a film, metal, or the like, and these base materials have different thicknesses and surface characteristics. Not only the printing base material but also the ink and the plate have large influence. Thus, the print curve is greatly different depending on the printing condition.

Herein, as illustrated in Figure 3A, the print curve means a curve obtained by plotting a relation between the data dot% and a substantial area ratio calculated by Murray-Davies formula with Tone Value Increment (TVI). The Tone Value Increment (TVI) is a numerical value representing a difference between a Tone Value and Tone, and is also called a dot gain. In the Murray-Davies formula, assuming that a colorimetric value of data dot% as a calculation target of the substantial area ratio is X in certain monochromatic gradation, the substantial area ratio corresponding to target data dot% is represented by the following expression. The data dot% may also be referred to as an area ratio on data. The colorimetric value may be ink density.

$$\text{Substantial area ratio} = \{(Xw - X)/(Xw - Xs)\} \times 100$$

Xw: colorimetric value of area ratio 0% (paper white)

Xs: colorimetric value of area ratio 100% (solid)

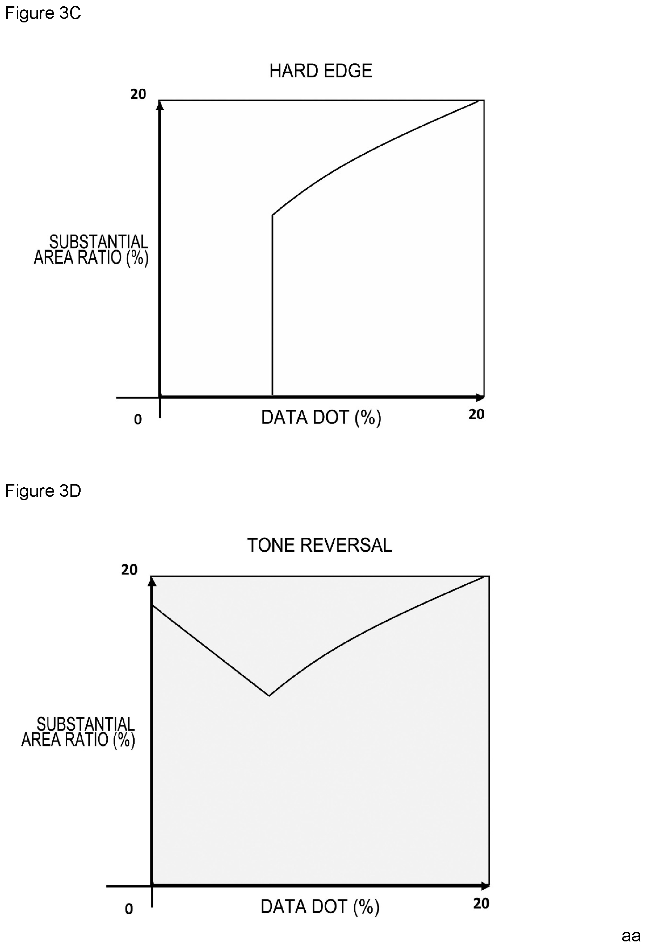

A screen is a control algorithm for determining the sizes and the number of dots formed on a surface of the printing original plate. In printing using dots, gradation expression can be achieved such that shading is expressed by performing printing with ink to be small points and controlling the number, sizes, and shapes of the points. By setting the screen to enable appropriate gradation expression in addition to setting of the correction curve described above, the printing plate that enables appropriate gradation expression can be obtained. On the other hand, in a case in which setting of the screen is inappropriate even if the manufacturing method for the printing plate other than the screen is the same, gradation expression particularly in a light portion becomes insufficient, and a hard edge as illustrated in Figure 3C, tone reversal as illustrated in Figure 3D, and the like may be caused. On the other hand, in a case in which setting of the screen is appropriate, fine gradation expression with beautiful fading as illustrated in Figure 3B is enabled.

A screen image parameter is information about a raster image corresponding to the screen, for example, an image of printed matter obtained when a certain screen is used represented as information about the raster image. The screen image parameter may include parameters such as the number, sizes, and shapes of the dots in each gradation region obtained by applying the screen. In the storage 150 of the formulation support device 100 in the present embodiment, the type of the screen and the screen image parameters such as the number, sizes, and shapes of the dots in each gradation region obtained by applying the screen may be recorded in association with each other.

Although there is no particular limitation, in the flexographic printing method, for example, the ink is supplied from the anilox roll to the flexographic printing plate (plate cylinder), and the ink is transferred to the printing base material from the flexographic printing plate (plate cylinder) to which the ink is supplied.

The printing condition information for the flexographic printing method is not particularly limited, but includes: an ink condition such as viscosity, solid content density, and pigment density; information about the anilox roll such as a cell shape, screen ruling, and capacity; information about a printing machine such as a model of a printing machine, a printing speed, a contact pressure between the anilox roll and the plate cylinder, a contact pressure between the printing base material and the plate cylinder, a drying speed, and a sleeve peripheral length; a cushion tape condition such as a type, hardness, and thickness of cushion tape for fixing the flexographic printing plate to the plate cylinder; a printing base material condition such as a type of the printing base material; and surface free energy, for example. Among these, at least one of a printing machine condition, an anilox condition, the ink condition, the printing base material condition, and the cushion tape condition is preferably included in the printing condition information. The anilox condition may be a condition related to the anilox roll such as a type of the anilox roll and a contact pressure between the anilox roll and the plate cylinder.

The printing quality is information representing the quality of printed matter from an optional viewpoint, and includes printing quality in predetermined gradation. The predetermined gradation is not particularly limited, but may include, for example, a shadow part, a halftone part, and a highlighted part. Herein, based on the substantial area ratio calculated for the printed matter by Murray/Davies formula, for example, it may be assumed that a region in which the substantial area ratio is 100% is a solid part, a region in which the substantial area ratio is equal to or larger than 80% and smaller than 100% is a shadow part, a region in which the substantial area ratio is equal to or larger than 20% and smaller than 80% is a halftone part, and a region in which the substantial area ratio is equal to or larger than 0% and smaller than 20% is a highlighted part. Herein, as a target value of the printing quality, a target value may be set based on a criterion and a standard described in existing literatures.

Indexes of printing quality in each type of gradation may be different among the shadow part, the halftone part, and the highlighted part. For example, in the highlighted part, relatively small dots are sparsely formed, so that formability, size, shape, and the like of the dot may be an index of the printing quality. On the other hand, in the shadow part, relatively large dots are densely formed and void dots may be generated, so that formability, size, shape, and the like of the void dot may be an index of the printing quality. In addition, in the halftone part positioned between the highlighted part and the shadow part, formability, size, shape, and the like of each of the dot and the void dot may be an index of the printing quality. In this manner, when the highlighted part is evaluated not only by the ink density but also by sizes, the number, and shapes of dots in the printed matter, the printing quality tends to be further improved.

Specifically, it is difficult to discriminate among Figure 3B to Figure 3D with only the index of ink density. The ink density of a solid part cannot be easily compatible with highlight quality. For example, fading tends to be disturbed when the ink density is increased, and printed matter with beautiful fading tends to be obtained when the ink density is low. At conventional printing sites, a present situation is that a person sees printed matter, and discriminates among Figures 3B, 3C, and 3D to find an optimum condition. However, with the formulation support device of the present embodiment, a condition for achieving beautiful fading as illustrated in Figure 3B can be found by further considering the number, sizes, shapes, and the like of the dots in addition to the ink density.

Also, at the shadow part and the halftone part, the printing quality information may include a print curve or at least one of the number, sizes, or shapes of the dots in the printed matter at a predetermined gradation part.

A target value of the number, sizes, or shapes of the dots may be set based on a minimum dot in a certain color in a raster image for a printing test. An excessively small dot cannot be stably formed, so that a minimum value of a printable dot may be technically limited. Thus, the image generation unit 113 described later may determine whether the dot can be formed based on the plate-making condition information and the printing condition information, and if the dot can be formed, may repeatedly estimate the size of the dot that can be formed, and perform optimization processing for searching for a condition under which the minimum dot can be formed. A model may be used for determining whether the dot can be formed, or estimating the size of the dot that can be formed.

The number, sizes, or shapes of the dots in the printed matter can be confirmed by magnifying and observing the printed matter using a microscope and the like. Accordingly, it is possible to configure data in which the information about the dots of the printed matter, and the printing condition information and the plate-making condition information for the printed matter are associated with each other. The printing plate has projections and depressions corresponding to the dots, and in that data, by causing a piece of data in which the dot is observed and a piece of data in which the dot is not observed by microscopic observation on the printed matter to be data for learning, it is possible to create a model for determining whether the dot can be formed based on the plate-making condition information and the printing condition information. For example, when determination is made based on the plate-making condition information and the printing condition information, it may be determined that the dot can be formed if the size of the dot to be formed is not 0.

The printing plate has projections and depressions corresponding to the dots, and by causing, in the data, a piece of data in which the dot is observed by microscopic observation on the printed matter to be data for learning, it is possible to create a model for estimating the size of the dot that can be formed.

The printing quality, especially indexes of printing quality at the halftone part, may include evaluation about color density such as ink density, a concealing property predicted value, an ink usage predicted value, and a readable character point number predicted value. Herein, the "concealing property" indicates uniformity of the ink transferred onto the printing base material.

Herein, the ink usage predicted value may be ink usage required for obtaining predetermined ink density or a predetermined concealing property. By considering the ink usage, it is possible to obtain the plate-making condition and the printing condition that can achieve both of printing quality and economic efficiency.

Herein, the readable character point number predicted value indicates a predicted value of a minimum character point that can be read by a person when being recorded under a predetermined plate-making condition and printing condition. Herein, the character point is a unit representing a size of a character or a figure. A unit basis of the character point is not particularly limited, but may be a DTP point, for example. As the readable character point number predicted value is smaller, characters other than the minimum character point can be printed more smoothly and clearly, and the printing quality can be further improved.

The index of the printing quality, particularly the printing quality in the highlighted part, is not particularly limited, but may include, for example, a print curve, or the number, sizes, or shapes of dots in a predetermined gradation part. Herein, the predetermined gradation part may be the highlighted part. The shape may be circularity, a long/short ratio, or the like. Particularly, the index of the printing quality in the highlighted part may be considered as a quality index of printing related to a gradation property.

The printing quality may further include printing quality at the solid part. The index of the printing quality at the solid part is not particularly limited, but may include the ink density, the concealing property, and the ink usage, for example. The printing quality at the solid part may be considered as a quality index of the color density or the concealing property. By considering the ink usage, it is possible to obtain the plate-making condition and the printing condition that can achieve both of printing quality and economic efficiency.

The printing quality may include printing quality at a character/thin-line part. The index of the printing quality at the character/thin-line part is not particularly limited, but may include readability and the concealing property, for example.

The image generation unit 113 described later may generate predicted image for each color represented by corrected dots by correcting, based on the plate-making condition of the printing plate and the printing condition, dots included in the color separation image in which the image to be printed is represented by dots of each color, using the prediction model described above.

Alternatively, the prediction unit 1121 may output correction information for correcting each dot included in the image to be printed based on the plate-making condition and the printing condition, and the image generation unit 113 may generate predicted image for each color represented by corrected dots by correcting the dots of the image to be printed based on the correction information.

The correction information is information for correcting each of the dots and/or void dots included in the image to be printed, and may include at least one of formability, the size, and the shape of the dot or void dot.

The prediction unit 1121 may output the correction information using the prediction model.

The image generation unit 113 predicts dots of each color in the printed matter obtained by printing the image to be printed based on the plate-making condition and the printing condition, based on the image to be printed, the plate-making condition of the printing plate, and the printing condition, and generates the predicted image for each color represented by the dots. For example, the image generation unit 113 generates the predicted image for each color represented by the corrected dots by correcting, based on the plate-making condition of the printing plate and the printing condition, dots included in the color separation image in which the image to be printed is represented by dots of each color. At this time, the image generation unit 113 may generate the predicted image for each color represented by the corrected dots by correcting the dots in the color separation image based on the prediction model, or may generate the predicted image for each color represented by the corrected dots by correcting the dots in the image to be printed using the correction information output from the prediction unit 1121. Thus, portions such as the halftone part and the highlighted part, which require fine expression of shading by dots, can be more appropriately reproduced in the predicted image for each color.

For example, the image generation unit 113 may calculate luminance for each pixel of the color separation image, and may recognize a series of pixels whose luminance is not 0 as one dot. The image generation unit 113 may also perform object detection processing on the color separation image using known methods such as an R-CNN method or a Yolo method to recognize dots. Alternatively, the image generation unit 113 may extract a dot, regarded as a dot, having an area smaller than an area of a circle whose diameter is an inverse of screen ruling (for example, when the "screen ruling" is 175 lines per inch (LPI), the image generation unit 113 may recognize, as a dot, a dot having an area smaller than an area (about 0.066 mm$^2$) of a circle whose diameter is 1 inch/175 $\approx$ 0.145 mm as a threshold). At this time, a dot area may be calculated by multiplying by a margin ratio as necessary. The image generation unit 113 may record each dot extracted from the color separation image in this manner in association with a position such as coordinates in the color separation image, the size and shape of the dot, and the like. In addition, an ID for uniquely identifying the dot may be assigned thereto.

The image generation unit 113 can obtain the corrected dots by performing correction, through parallel processing for each of the dots included in the color separation image, from at least one of viewpoints of formability of the dot, the size of the dot, and the shape of the dot (refer to Figure 2D). In this manner, by converting the dots included in the color separation image into the corrected dots, it is possible to obtain the predicted image for each color in a case where recording is actually performed under the predetermined plate-making condition and printing condition.

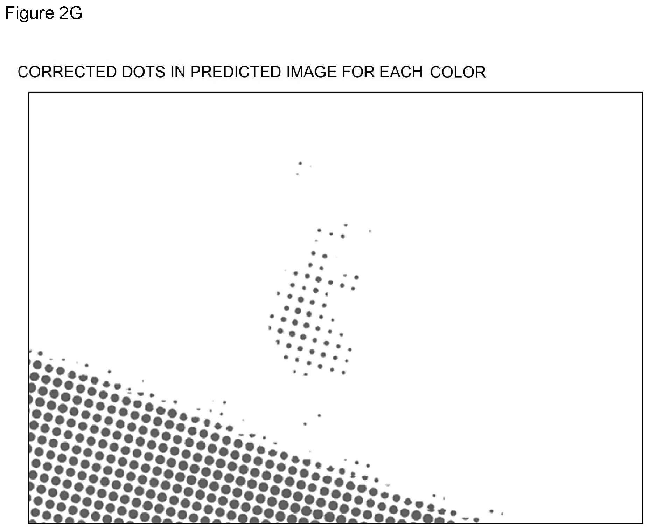

Figure 2F illustrates an example of the color separation image, and Figure 2G illustrates an example of the predicted image for each color including the corrected dots obtained by correcting each of the dots included in the color separation image through parallel processing.

In addition, the image generation unit 113 may correct the void dots included in the color separation image based on the plate-making condition of the printing plate and the printing condition to generate the predicted image for each color including the corrected void dots. Thus, it is possible to more appropriately reproduce, in the predicted image for each color, representation of the shadow part in which adjacent dots are in contact with each other and cannot be recognized as dots.

For example, the image generation unit 113 may calculate luminance for each pixel of the color separation image, and may recognize a series of pixels whose luminance is 0 as one void dot. The image generation unit 113 may also perform object detection processing on the color separation image using known methods such as an R-CNN method or a Yolo method to recognize void dots. The image generation unit 113 may extract a closed region, regarded as a void dot, having an area smaller than an area of a circle whose diameter is an inverse of screen ruling. At this time, a void dot area may be calculated by multiplying by a margin ratio as necessary. The image generation unit 113 may record each void dot extracted from the color separation image in this manner in association with a position such as coordinates in the color separation image, the size and shape of the dot, and the like. In addition, an ID for uniquely identifying the void dot may be assigned thereto.

The image generation unit 113 obtains the corrected void dots by performing correction, through parallel processing for each of the void dots included in the color separation image, from at least one of the viewpoints of formability, the size, and the shape (refer to Figure 2E). In this manner, by converting the dots included in the color separation image into the corrected dots, it is possible to obtain the predicted image for each color in a case where recording is actually performed under the predetermined plate-making condition and printing condition.

The image composition unit 114 synthesizes a composite predicted image based on a plurality of predicted image for each colors. Specifically, the image composition unit 114 outputs, as the composite predicted image, aggregated images of the respective colors of printed matter (predicted image for each colors) that would be obtained when printing is performed, instead of actually performing printing, by superimposing the plurality of predicted image for each colors obtained as described above. Thus, a printing result can be confirmed as an image without actually performing printing.

The evaluation unit 115 may determine whether a relation between the information about the dots in the color separation image and the information about the corrected dots in the predicted image for each color satisfies a target index.

For example, the evaluation unit 115 may determine whether a difference between the number of dots in the color separation image and the number of corrected dots in the predicted image for each color satisfies a target index. As illustrated in Figure 2D, when the dot is small, the corrected dot is not formed in some cases depending on the plate-making condition and the printing condition, so that a difference may occur between the number of dots in the color separation image and the number of corrected dots in the predicted image for each color. When the difference is small, the color separation image and the predicted image for each color can be regarded as being more approximate. Particularly, when this difference is small, the predicted image for each color can reproduce the color separation image more accurately in gradation of the highlighted part represented by small-diameter dots, or the like.

A method for calculating a difference in the number of dots is not particularly limited, but may include, for example, a method of counting the number of corrected dots determined to be unformable in the correction processing of the dots in the color separation image by the image generation unit 113. At this point, the dot as a target may be a dot having an area smaller than an area of a circle whose diameter is an inverse of screen ruling.

The evaluation unit 115 may also determine whether a difference between an area occupied by the dots in the color separation image and an area occupied by the corrected dots in the predicted image for each color satisfies a target index. As illustrated in Figure 2D, the corrected dot may be formed to be larger depending on the plate-making condition and the printing condition, so that a difference may occur between the area occupied by the dots in the color separation image and the area occupied by the corrected dots in the predicted image for each color. When the difference is small, the color separation image and the predicted image for each color can be regarded as being more approximate.

A method for calculating the difference in the area occupied by the dots is not particularly limited, but may include, for example, a method of counting an area of the corrected dots determined to be unformable in the correction processing of the dots in the color separation image by the image generation unit 113, counting a difference between an area of the corrected dots determined to be formable and an area of original dots thereof, and calculating a sum total thereof.

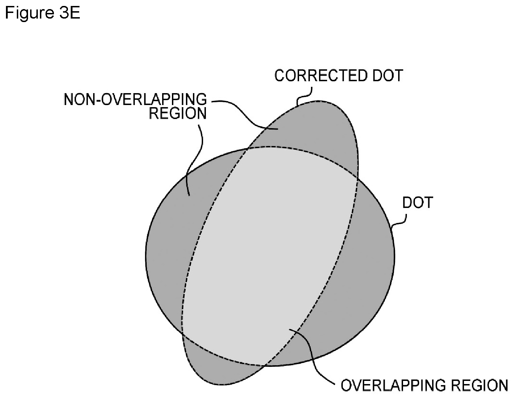

Specifically, as illustrated in Figure 3E showing a schematic diagram of overlapping between the dot in the color separation image and the corrected dot, an area of a region in which the corrected dot and its original dot do not overlap may be counted, and a value thereof may be accumulated for each dot. A difference in the area occupied by the dots obtained in this manner is a value reflecting not only a difference in sizes of the dots but also shapes and distortion of the dots. When this difference is small, the predicted image for each color can reproduce the color separation image more accurately in the highlighted part and the halftone part. At this point, the dot as a target may be a dot having an area smaller than an area of a circle whose diameter is an inverse of screen ruling.

In addition, from the same viewpoint as described above, the void dots may be evaluated instead of the dots. Specifically, the evaluation unit 115 may determine whether a difference between the number of void dots in the color separation image and the number of corrected void dots in the predicted image for each color satisfies a target index. The evaluation unit 115 may also determine whether a difference between a total area of the void dots in the color separation image and a total area of the corrected void dots in the predicted image for each color satisfies a target index.

The evaluation unit 115 determines whether differences obtained as described above, such as a difference in the number of dots, a difference in dot areas, a difference in the number of shadows, and a difference in shadow areas, satisfy a predetermined target index. When the predetermined target index is satisfied, the image generation unit 113 may output the predicted image for each color represented by the corrected dots by correcting the dots included in the color separation image based on the changed plate-making condition and printing condition.

The evaluation unit 115 may also evaluate reproducibility between the composite predicted image and the image to be printed. A method for evaluating reproducibility between images is not particularly limited as long as it is a conventionally known method, but may include, for example, a method using an average of pixel values and a method using a histogram of pixel values.

The condition generation unit 116 changes the plate-making condition and/or the printing condition used by the image generation unit 113 when the information about the dots in the predicted image for each color does not satisfy the predetermined condition such as the target index described above, or when the reproducibility does not satisfy the target index. The image generation unit 113 may obtain a new predicted image for each color represented by the corrected dots by correcting the dots included in the color separation image based on the changed plate-making condition and printing condition. In the present embodiment, by changing the plate-making condition and/or the printing condition based on the predicted image for each color represented by the corrected dots, the conditions are changed based on an image close to actual printed matter, so that an appropriate plate-making condition and/or printing condition can be generated. As a result, calculation resources for generating conditions can be saved. Furthermore, since the number of times of test printing required for adjusting the plate-making condition and/or the printing condition can be suppressed, resources related to the test printing can be saved.

Herein, the target index may be, for example, an upper limit threshold of a difference in the number of dots, a difference in dot areas, a difference in the number of voids in the shadow part, and a difference in shadow areas, or a predetermined threshold of reproducibility.

The condition generation unit 116 may also generate predicted image for each color different from the predicted image for each color described above (hereinafter also referred to as "new predicted image for each color") in accordance with the reproducibility. For example, when a color histogram is used as the reproducibility, the condition generation unit 116 may generate the predicted image for each color so that the reproducibility is improved, in accordance with the reproducibility.

When the condition generation unit 116 generates a new predicted image for each color and/or a new printing index of each color of ink, the image generation unit 113, the image composition unit 114, and the evaluation unit 115 may perform the processing again based on the new predicted image for each color and/or the new printing index of each color of ink. Generation of the predicted image for each color and evaluation of the reproducibility may be performed until the reproducibility satisfies the target index.

In the optimization processing performed by the evaluation unit 115 and the condition generation unit 116 to satisfy the target index, a known algorithm such as a steepest descent method, a genetic algorithm, or Bayesian optimization may be used for determination.

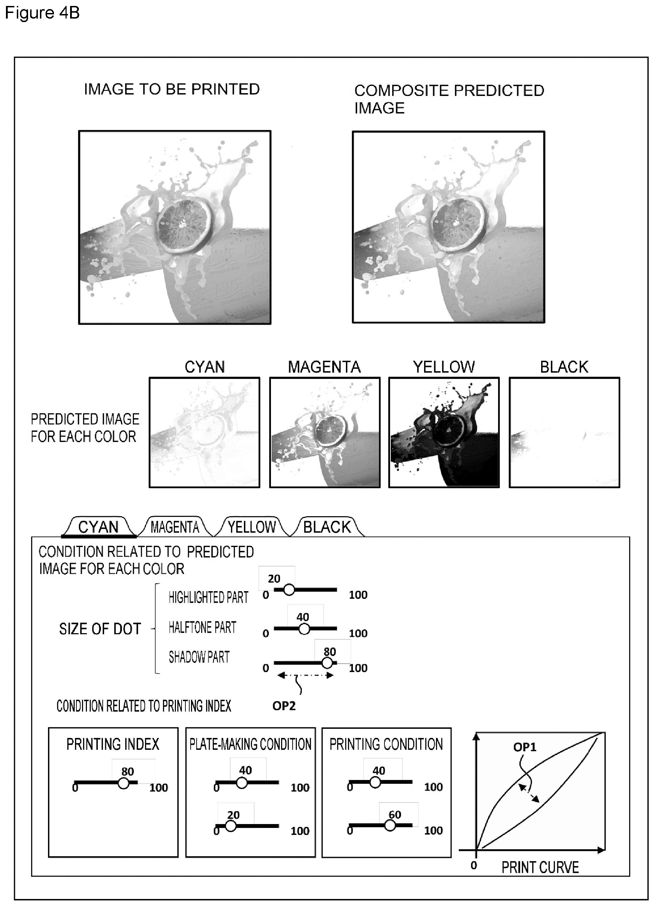

The correction unit 117 receives correction information of the predicted image for each color in response to a user's operation. At this point, the image generation unit 113 may generate a corrected predicted image for each color based on the correction information, and the image composition unit 114 may synthesize a composite predicted image based on a plurality of corrected predicted image for each colors. For example, in the example illustrated in Figure 4B, when a user moves a print curve (OP1) or moves a parameter slider (OP2), the correction unit 117 may receive the correction information in conjunction therewith.

Accordingly, the corrected predicted image for each color can be generated in response to the user's operation. The parameters that can be controlled by the user in generating corrected raster image information are not particularly limited as long as they are related to the predicted image for each color.

The display control unit 118 may perform display control so that the composite predicted image synthesized by the image composition unit 114 can be compared with the image to be printed. The composite predicted image may include, in addition to a composite predicted image obtained based on the predicted image for each colors generated by the RIP processing unit 111, a composite predicted image obtained based on predicted image for each colors generated by the condition generation unit 116, and a composite predicted image obtained based on corrected predicted image for each colors generated by the correction unit 117.

Accordingly, although on the display device 131, the vector image and the composite predicted image can be shown in comparison, so that a finish of the printed matter can be visually checked and the finish can be adjusted.

Figure 4B illustrates an example of a screen on which the display control unit 118 performs display control on the display device 131. In the example illustrated in Figure 4B, display control is performed on the vector image and the composite predicted image. The display control unit 118 may further perform display control on the raster image for each color constituting the composite predicted image.

Furthermore, in the example illustrated in Figure 4B, display control is performed on parameters related to the printing index, the plate-making condition, and the printing condition for each of colors of ink such as cyan, magenta, and yellow. For example, when the user moves a print curve (OP1) or moves a parameter slider (OP2), the correction unit 117 may generate correction information in conjunction therewith, may perform display control on the corrected predicted image for each color instead of the predicted image for each color that has already been displayed, and may perform display control on the corrected composite predicted image instead of the composite predicted image that has already been displayed.

The display control unit 118 may also perform display control on the plate-making condition and/or the printing condition related to the composite predicted image.

1.3. Operation processing

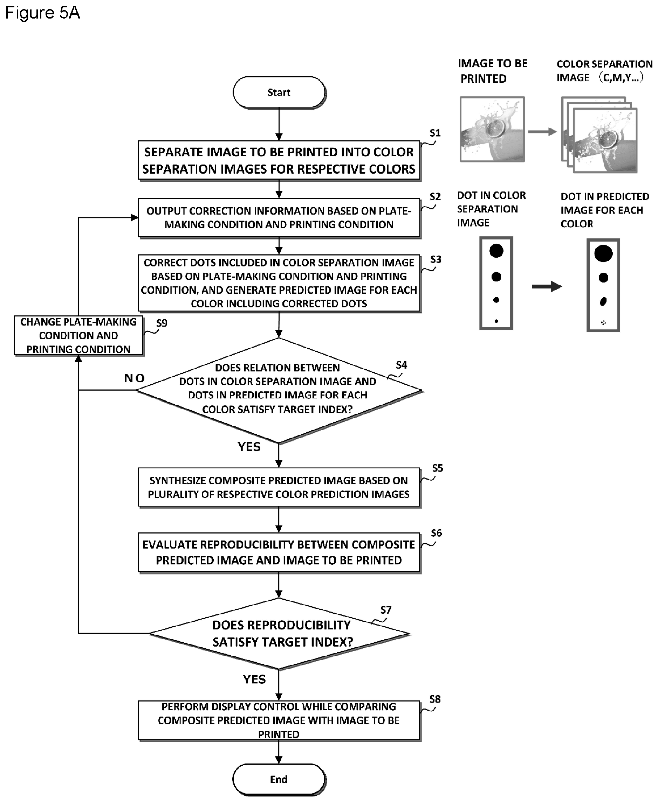

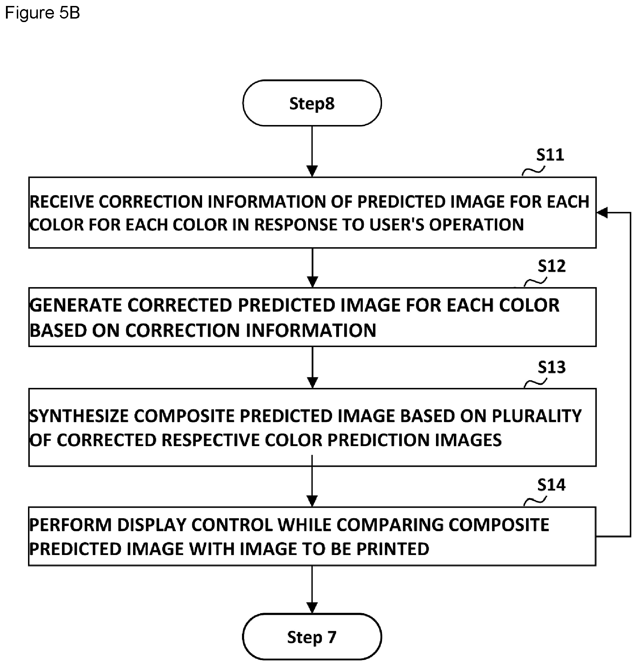

Next, the following describes an operation of the formulation support device 100. Figure 5A and Figure 5B are flowcharts illustrating an example of processing performed by the formulation support device 100. The processing performed by the formulation support device 100 is not limited to Figure 5A and Figure 5B.

First, the following describes an aspect illustrated in Figure 5A.

At Step S1, the RIP processing unit 111 separates the image to be printed into color separation images represented by dots of respective colors. At this point, the RIP processing unit 111 may output, based on information about a type of ink color, a color separation image corresponding to the color.

When an appropriate plate-making condition and printing condition are searched for by the searching process described above using a test pattern, at Step S2, the learning unit 112 outputs correction information based on the plate-making condition and the printing condition. The learning unit 112 may predict information about the printing indexes of the respective colors of ink in a case where it is assumed that the flexographic printing plate manufactured under the plate-making condition is printed under the printing condition. Instead of this, at Step S2, the learning unit 112 may predict printing indexes of the respective colors of ink based on the image to be printed or the color separation images.

At Step S3, the image generation unit 113 corrects the dots included in the color separation image based on the plate-making condition and the printing condition, and generates the predicted image for each color including the corrected dots. At this point, the predicted image for each color may be generated for each color of ink based on the color separation image and the prediction model. The predicted image for each color is a prediction image when ink of a predetermined color is printed.

At Step S4, the evaluation unit 115 evaluates whether a relation between the information about the dots in the color separation image and the information about the corrected dots in the predicted image for each color satisfies a target index.

When the evaluation unit 115 evaluates that the target index is satisfied, at Step S5, the image composition unit 114 synthesizes a composite predicted image based on the plurality of predicted image for each colors. The composite predicted image is a prediction image when all inks are printed, and is a prediction image of the printed matter obtained when printing is actually performed.

Furthermore, at Step S6, the evaluation unit 115 performs an evaluation step of evaluating reproducibility between the composite predicted image and the vector image, and when the evaluation unit 115 determines that the reproducibility satisfies a predetermined target index at Step S7, the display control unit 118 performs display control while comparing the composite predicted image with the image to be printed at Step S8. A method of comparison is not particularly limited. For example, as illustrated in Figure 4B, the composite predicted image and the vector image may be displayed side by side.

On the other hand, when the evaluation unit 115 evaluates that the target index is not satisfied at Step S4, the condition generation unit 116 may change the plate-making condition and the printing condition at Step S9, and may perform Step S2 again. In addition, when the evaluation unit 115 determines that the reproducibility does not satisfy the predetermined target index at Step S7, the condition generation unit 116 may change the plate-making condition and the printing condition at Step S9, and may perform Step S2 again. These processes may be continued until the target index is satisfied.

Next, the following describes an aspect illustrated in Figure 5B. The processing illustrated in Figure 5B can be inserted after Step S8 in Figure 5A, for example.

At Step 11, the correction unit 117 receives correction information of the predicted image for each color in response to a user's operation. At this point, at Step S8, based on a comparison between the composite predicted image and the image to be printed subjected to display control, the user may generate the correction information through a screen operation illustrated in Figure 4B.

At Step S12, the image generation unit 113 generates the predicted image for each color for each color of ink based on the correction information, and at Step S13, the image composition unit 114 synthesizes a composite predicted image based on the plurality of predicted image for each colors. At Step S14, the display control unit 118 may perform display control while comparing the composite predicted image with the vector image.

By performing Steps S12 to S14, in the screen operation illustrated in Figure 4B, for example, the composite predicted image may be changed or the predicted image for each color may be changed in response to dragging of the print curve by the user.

2. Information processing method

In the information processing method of the present embodiment, the formulation support device performs: an image generation step of predicting, based on the image to be printed, the plate-making condition of the printing plate, and the printing condition, the dots of each color in the printed matter obtained by printing the image to be printed based on the plate-making condition and the printing condition, and of generating the predicted image for each color represented by the dots; and an image composition step of compositing the composite predicted image based on a plurality of the predicted image for each colors.

The program of the present embodiment may cause the formulation support device to perform: an image generation step of generating the predicted image for each color represented by the corrected dots by correcting, based on the plate-making condition of the printing plate and the printing condition, the dots included in the color separation image in which the image to be printed is represented by the dots of each color; and an image composition step of compositing the composite predicted image based on a plurality of the predicted image for each colors.

Specific aspects of the method in the present embodiment are described in the above operation processing, so that detailed description thereof will not be repeated herein.

3. Program

The program of the present embodiment causes the formulation support device to implement: the image generation unit configured to predict, based on the image to be printed, the plate-making condition of the printing plate, and the printing condition, the dots of each color in the printed matter obtained by printing the image to be printed based on the plate-making condition and the printing condition, and to generate the predicted image for each colors represented by the dots; and the image composition unit configured to synthesize the composite predicted image based on a plurality of the predicted image for each colors.

The program of the present embodiment may cause the formulation support device to perform: the image generation step of generating the predicted image for each color represented by the corrected dots by correcting, based on the plate-making condition of the printing plate and the printing condition, the dots included in the color separation image in which the image to be printed is represented by the dots of each color; and the image composition step of compositing the composite predicted image based on a plurality of the predicted image for each colors.

The program may be recorded in a readable recording medium. Specific aspects of the processing performed by the program of the present embodiment are described in the above operation processing, so that detailed description thereof will not be repeated herein.

**Industrial Applicability**

The present invention has industrial applicability as a device that supports formulation of a plate-making condition and a printing condition in flexographic printing.

**Reference Signs List**

100 formulation support device

110 processor

111 RIP processing unit

112 learning unit

1121 prediction unit

113 image generation unit

114 image composition unit

115 evaluation unit

116 condition generation unit

117 correction unit

118 display control unit

120 communication interface

130 input/output interface

131 display device

140    memory

150    storage

151    print data

160    bus

200    plate-making device

300    printing device

**Claims**

1. A formulation support device comprising:

   an image generation unit configured to predict, based on a image to be printed, a plate-making condition of a printing plate, and a printing condition, dots of each color in printed matter obtained by printing the image to be printed based on the plate-making condition and the printing condition, and to generate predicted image for each color represented by the dots; and
   an image composition unit configured to synthesize a composite predicted image based on a plurality of the predicted image for each colors.

2. The formulation support device according to claim 1, further comprising:

   a prediction unit configured to output correction information for correcting each dot included in the image to be printed based on the plate-making condition and the printing condition, wherein
   the image generation unit generates the predicted image for each color represented by corrected dots by correcting the dots of the image to be printed based on the correction information.

3. The formulation support device according to claim 2, wherein
   the correction information is at least one of formability, size, and shape.

4. The formulation support device according to claim 1, wherein

   a closed region formed by adjacent ones of the plurality of dots being in contact with each other is recognized as a void dot, and
   the image generation unit generates the predicted image for each color by correcting the void dot included in the image to be printed based on the plate-making condition of the printing plate and the printing condition, and by generating a corrected void dot.

5. The formulation support device according to claim 4, wherein
   correction information for correcting the void dot based on the plate-making condition and the printing condition is at least one of formability, size, and shape.

6. The formulation support device according to claim 1, further comprising:
   a display control unit configured to display the composite predicted image and the image to be printed to be comparable with each other.

7. The formulation support device according to claim 1, further comprising:
   a display control unit configured to perform display control on the plate-making condition and/or the printing condition related to the composite predicted image.

8. The formulation support device according to claim 1, further comprising:
   a condition generation unit configured to change the plate-making condition and/or the printing condition when information about the dots in the predicted image for each color does not satisfy a predetermined condition.

9. The formulation support device according to claim 1, further comprising:

a correction unit configured to receive correction information of the predicted image for each color in response to a user's operation, wherein

the image generation unit generates a corrected predicted image for each color based on the correction information, and

the image composition unit synthesizes a corrected composite predicted image based on the corrected predicted image for each color.

10. An information processing method, performed by a formulation support device, comprising:

an image generation step of predicting, based on a image to be printed, a plate-making condition of a printing plate, and a printing condition, dots of each color in printed matter obtained by printing the image to be printed based on the plate-making condition and the printing condition, and of generating predicted image for each color represented by the dots; and

an image composition step of compositing a composite predicted image based on a plurality of the predicted image for each colors.

11. A program that causes a formulation support device to perform:

an image generation step of predicting, based on a image to be printed, a plate-making condition of a printing plate, and a printing condition, dots of each color in printed matter obtained by printing the image to be printed based on the plate-making condition and the printing condition, and of generating predicted image for each color represented by the dots; and

an image composition step of compositing a composite predicted image based on a plurality of the predicted image for each colors.

Figure 1

Figure 2A

100

120
COMMUNICATION INTERFACE

110
PROCESSOR

RIP PROCESSING UNIT — 111
LEARNING UNIT — 112
PREDICTION UNIT — 1121
IMAGE GENERATION UNIT — 113
IMAGE COMPOSITION UNIT — 114
EVALUATION UNIT — 115
CONDITION GENERATION UNIT — 116
CORRECTION UNIT — 117
DISPLAY CONTROL UNIT — 118

130
INPUT/OUTPUT INTERFACE
DISPLAY DEVICE — 131

150
STORAGE
PRINT DATA — 151

160

140
MEMORY

Figure 2B

| |
|---|
| <u>PRINTING ID</u> |
| INFORMATION ABOUT COLOR SEPARATION IMAGE (INCLUDING INFORMATION ABOUT DOTS) |
| INFORMATION ABOUT EXECUTED PRINTING CONDITION |
| INFORMATION ABOUT EXECUTED PLATE-MAKING CONDITION |
| INFORMATION ABOUT ACTUAL PRINTING QUALITY (INCLUDING INFORMATION ABOUT PRINTED DOTS) |
| ... |

151

Figure 2C

INFORMATION ABOUT DOTS INCLUDED IN COLOR SEPARATION IMAGE

PLATE-MAKING CONDITION

PRINTING CONDITION

CALIBRATION INFORMATION (PREDICTION MODEL)

INFORMATION ABOUT CORRECTED DOTS

Figure 2D

| DOT IN COLOR SEPARATION IMAGE | CORRECTED DOT IN PREDICTED IMAGE FOR EACH COLOR | FORMABILITY OF DOT | DOT SIZE | DOT SHAPE (CIRCULARITY, INCLINATION) |
|---|---|---|---|---|
| | | Yes | 120% | 0.99, −0.030 |
| PLATE-MAKING CONDITION : ... PRINTING CONDITION : ... | | Yes | 100% | 1.00, −0.000 |
| | | Yes | 110% | 0.90, −0.100 |
| | UNFORMABLE | No | — | — |

Figure 2E

| VOID DOT IN COLOR SEPARATION IMAGE DOT | CORRECTED VOID DOT IN PREDICTED IMAGE FOR EACH COLOR CORRECTED DOT | FORMABILITY OF VOID DOT | VOID DOT SIZE | VOID DOT SHAPE (LONG/SHORT RATIO OF ELLIPSE APPROXIMATION) |
|---|---|---|---|---|
| | | Yes | 80% | 0.98 |
| PLATE-MAKING CONDITION : ... PRINTING CONDITION : ... | | Yes | 70% | 0.90 |
| | | No | — | — |

Figure 2F

DOTS IN COLOR SEPARATION IMAGE

Figure 2G

CORRECTED DOTS IN PREDICTED IMAGE FOR EACH COLOR

Figure 2H

| SHAPE CONVERSION TARGET DOT | | | PLATE-MAKING AND PRINTING CONDITIONS | | | | | | | | | | | | | | | | | | | | | | | | OBJECTIVE VARIABLE (INFORMATION ABOUT DOTS AFTER PRINTING) | | | |
|---|---|---|---|---|---|---|---|---|---|---|---|---|---|---|---|---|---|---|---|---|---|---|---|---|---|---|---|---|---|---|---|
| ID | TYPE | SCREEN RULING OF IMAGE | PLATE | PLATE THICKNESS | SLEEVE PERIPHERAL LENGTH | ANILOX MANUFACTURER | ANILOX SCREEN RULING | ANILOX CAPACITY | SCREEN TYPE | SCREEN ANGLE | Boost | MC | PRINTING BASE MATERIAL | DGC TYPE | RATIO @50% | min.dot | h | s | k | INK TYPE | INK VISCOSITY | CUSHION TAPE | PRINTING PRESSURE | ANILOX PRESSURE | PRINTING SPEED | DRYING TEMPERATURE | SIZE Δ | SHAPE (CIRCULARITY) | INCLINATION (ELLIPSE APPROXIMATION) | FORMATION DETERMINATION |
| d1 | DOT | 150 | A | 1.14 | 375 | E | 850 | 5 | H | 75 | 150 | K | PET | Linear | 50 | 1.2 | 12 | 8 | 0 | O | 14 | R | 50 | 50 | 150 | 80 | 0.0 | 0.8 | 0.8 | ○ |
| d2 | DOT | 150 | B | 1.7 | 450 | F | 600 | 8 | I | 75 | 170 | L | OPP | A | 70 | 2.4 | 18 | 12 | 0 | P | 11.3 | S | 70 | 30 | 100 | 60 | 12.9 | 0.4 | 0.6 | ○ |
| d3 | DOT | 150 | C | 1.14 | 520 | G | 1000 | 4 | J | 75 | 200 | M | PET | H | 20 | 0.4 | 24 | 37 | 0 | Q | 15.2 | S | 30 | 30 | 200 | 50 | -8.6 | 0.6 | 0.2 | ○ |
| d4 | DOT | 150 | D | 2.54 | 650 | F | 850 | 5 | H | 75 | 150 | N | OPP | Linear | 50 | 1.2 | 33 | 22 | 5 | Q | 14.2 | T | 50 | 50 | 150 | 80 | 0.0 | 0.1 | 1.2 | × |
| ·· | ·· | ·· | ·· | ·· | ·· | ·· | ·· | ·· | ·· | ·· | ·· | ·· | ·· | ·· | ·· | ·· | ·· | ·· | ·· | ·· | ·· | ·· | ·· | ·· | ·· | ·· | ·· | ·· | ·· | ·· |

Figure 2I

| SHAPE CONVERSION SHAPE CONVERSION TARGET: VOID | | | | | | PLATE-MAKING AND PRINTING CONDITIONS | | | | | | | | | | | | | | | | | | OBJECTIVE VARIABLE (INFORMATION ABOUT VOID DOTS AFTER PRINTING) | | | |
|---|---|---|---|---|---|---|---|---|---|---|---|---|---|---|---|---|---|---|---|---|---|---|---|---|---|---|---|
| ID | SCREEN RULING TYPE OF IMAGE | PLATE | PLATE THICKNESS | SLEEVE (PERIPHERAL LENGTH) | ANILOX MANUFACTURER | ANILOX SCREEN RULING | ANILOX CAPACITY | SCREEN TYPE | SCREEN ANGLE | Boost | MC | PRINTING BASE MATERIAL | DGC TYPE | RATIO @50% | min. dot | h | s | k | INK TYPE | INK VISCOSITY | CUSHION TAPE | PRINTING PRESSURE | ANILOX PRESSURE | PRINTING SPEED | DRYING TEMPERATURE | SIZE △ | SHAPE (LONG/SHORT RATIO OF ELLIPSE APPROXIMATION) | VOID INCLINATION (ELLIPSE APPROXIMATION) | FORMATION DETERMINATION |
| v1 | VOID 150 | A | 1.14 | 375 | E | 850 | 5 | H | 75 | 150 | K | PET | Linear | 50 | 1.2 | 12 | 8 | 0 | O | 14 | R | 50 | 50 | 150 | 80 | 0.0 | 0.9 | 0.8 | ○ |
| v2 | VOID 150 | B | 1.7 | 450 | F | 600 | 8 | I | 75 | 170 | L | OPP | A | 70 | 2.4 | 18 | 12 | 0 | P | 11.3 | S | 70 | 30 | 100 | 60 | -5.9 | 0.6 | 0.6 | × |
| v3 | VOID 150 | C | 1.14 | 520 | G | 1000 | 4 | J | 75 | 200 | M | PET | H | 20 | 0.4 | 24 | 37 | 0 | Q | 15.2 | S | 30 | 30 | 200 | 50 | 19.6 | 0.7 | 0.2 | ○ |
| v4 | VOID 150 | D | 2.54 | 650 | F | 850 | 5 | H | 75 | 150 | N | OPP | Linear | 50 | 1.2 | 33 | 22 | 5 | Q | 14.2 | T | 50 | 50 | 150 | 80 | 0.0 | 0.2 | 1.2 | ○ |
| : | : | : | : | : | : | : | : | : | : | : | : | : | : | : | : | : | : | : | : | : | : | : | : | : | : | : | : | : | : |

Figure 2J

PLATE-MAKING AND PRINTING CONDITIONS

| DOT | | | | | | | | | | | | | | | | | | | | | | | | | |
|---|---|---|---|---|---|---|---|---|---|---|---|---|---|---|---|---|---|---|---|---|---|---|---|---|---|
| CONDITION | SCREEN RULING OF IMAGE | PLATE | PLATE THICKNESS | SLEEVE PERIPHERAL LENGTH | ANILOX MANUFACTURER | ANILOX SCREEN RULING | ANILOX CAPACITY | SCREEN TYPE | SCREEN ANGLE | Boost | MC | PRINTING BASE MATERIAL | DGC TYPE | RATIO @50% | min. dot | h | s | k | INK TYPE | INK VISCOSITY | CUSHION TAPE | PRINTING PRESSURE | ANILOX PRESSURE | PRINTING SPEED | DRYING TEMPERATURE |
| 1 | 150 | A | 1.14 | 375 | E | 850 | 5 | H | 75 | 150 | K | PET | Linear | 50 | 1.2 | 12 | 8 | 0 | O | 14 | R | 50 | 50 | 150 | 80 |
| 2 | 150 | B | 1.7 | 450 | F | 600 | 8 | I | 75 | 170 | L | OPP | A | 70 | 2.4 | 18 | 12 | 0 | P | 11.3 | S | 70 | 30 | 100 | 60 |
| 3 | 150 | C | 1.14 | 520 | G | 1000 | 4 | J | 75 | 200 | M | PET | H | 20 | 0.4 | 24 | 37 | 0 | Q | 15.2 | S | 30 | 30 | 200 | 50 |
| 4 | 150 | D | 2.54 | 650 | F | 850 | 5 | H | 75 | 150 | N | OPP | Linear | 50 | 1.2 | 33 | 22 | 5 | Q | 14.2 | T | 50 | 50 | 150 | 80 |

CORRECTED DOT

| CONDITION | SIZE Δ | AVERAGE VALUE OF CIRCULARITY | AVERAGE VALUE OF ELLIPSE INCLINATION | FORMATION DETERMINATION |
|---|---|---|---|---|
| 1 | 0.0 | 0.8 | 0.8 | ○ |
| 2 | 12.9 | 0.4 | 0.6 | ○ |
| 3 | -8.6 | 0.6 | 0.2 | ○ |
| 4 | 0.0 | 0.1 | 1.2 | × |

CORRECTED VOID DOT

| SIZE Δ | SHAPE AVERAGE VALUE (LONG/SHORT RATIO OF ELLIPSE APPROXIMATION) | FORMATION DETERMINATION |
|---|---|---|
| 0.0 | 0.9 | ○ |
| -5.9 | 0.6 | × |
| 19.6 | 0.7 | ○ |
| 0.0 | 0.2 | ○ |

Figure 3A

Figure 3B

Figure 3C

HARD EDGE

SUBSTANTIAL AREA RATIO (%)

0    DATA DOT (%)    20

Figure 3D

TONE REVERSAL

SUBSTANTIAL AREA RATIO (%)

0    DATA DOT (%)    20

aa

Figure 3E

Figure 4A

DIGITAL DESIGN IMAGE TO BE PRINTED

PIXEL REPRESENTATION OF DIGITAL IMAGE

COLOR LAYER INFORMATION INCLUDED IN IMAGE TO BE PRINTED

CYAN    MAGENTA    YELLOW    BLACK

DOT REPRESENTATION ON PRINTING PLATE

COLOR SEPARATION IMAGE

CYAN    MAGENTA    YELLOW    BLACK

PRINTED MATTER

Figure 4B

Figure 5A

Figure 5B

```
                        ┌─────────────┐
                        │    Step8     │
                        └──────┬──────┘
                               │                              S11
                               ▼                              ⌇
┌──────────────────────────────────────────────────────────────┐
│ RECEIVE CORRECTION INFORMATION OF PREDICTED IMAGE FOR EACH    │◄──┐
│ COLOR FOR EACH COLOR IN RESPONSE TO USER'S OPERATION          │   │
└──────────────────────────┬───────────────────────────────────┘   │
                           │                              S12       │
                           ▼                              ⌇         │
┌──────────────────────────────────────────────────────────────┐   │
│ GENERATE CORRECTED PREDICTED IMAGE FOR EACH COLOR             │   │
│ BASED ON CORRECTION INFORMATION                              │   │
└──────────────────────────┬───────────────────────────────────┘   │
                           │                              S13       │
                           ▼                              ⌇         │
┌──────────────────────────────────────────────────────────────┐   │
│ SYNTHESIZE COMPOSITE PREDICTED IMAGE BASED ON PLURALITY       │   │
│ OF CORRECTED RESPECTIVE COLOR PREDICTION IMAGES              │   │
└──────────────────────────┬───────────────────────────────────┘   │
                           │                              S14       │
                           ▼                              ⌇         │
┌──────────────────────────────────────────────────────────────┐   │
│ PERFORM DISPLAY CONTROL WHILE COMPARING COMPOSITE            │───┘
│ PREDICTED IMAGE WITH IMAGE TO BE PRINTED                     │
└──────────────────────────┬───────────────────────────────────┘
                           │
                           ▼
                   ┌─────────────┐
                   │   Step 7    │
                   └─────────────┘
```

## INTERNATIONAL SEARCH REPORT

| | International application No. |
|---|---|
| | **PCT/JP2024/027815** |

---

**A. CLASSIFICATION OF SUBJECT MATTER**

***B41F 33/16*(2006.01)i**

FI: B41F33/16

According to International Patent Classification (IPC) or to both national classification and IPC

---

**B. FIELDS SEARCHED**

Minimum documentation searched (classification system followed by classification symbols)

B41F33/16

---

Documentation searched other than minimum documentation to the extent that such documents are included in the fields searched

Published examined utility model applications of Japan 1922-1996
Published unexamined utility model applications of Japan 1971-2024
Registered utility model specifications of Japan 1996-2024
Published registered utility model applications of Japan 1994-2024

---

Electronic data base consulted during the international search (name of data base and, where practicable, search terms used)

---

**C. DOCUMENTS CONSIDERED TO BE RELEVANT**

| Category* | Citation of document, with indication, where appropriate, of the relevant passages | Relevant to claim No. |
|---|---|---|
| Y | JP 2003-246039 A (DAINIPPON SCREEN MFG. CO., LTD.) 02 September 2003 (2003-09-02)<br>    paragraphs [0018]-[0059], fig. 1-5 | 1-3, 6-11 |
| Y | WO 2009/145260 A1 (KOMORI CORPORATION) 03 December 2009 (2009-12-03)<br>    paragraphs [0014]-[0057], fig. 1-8 | 1-3, 6-11 |
| Y | JP 2003-237016 A (MITSUBISHI HEAVY INDUSTRIES, LTD.) 26 August 2003 (2003-08-26)<br>    paragraphs [0017]-[0021], [0029]-[0031], fig. 1, 3 | 1-3, 6-11 |
| A | JP 2008-213484 A (MITSUBISHI HEAVY INDUSTRIES, LTD.) 18 September 2008 (2008-09-18)<br>    entire text, all drawings | 1-11 |
| A | JP 2016-49768 A (FUJIFILM CORPORATION) 11 April 2016 (2016-04-11)<br>    entire text, all drawings | 1-11 |

---

☐ Further documents are listed in the continuation of Box C.    ☑ See patent family annex.

---

| * Special categories of cited documents: | "T" later document published after the international filing date or priority date and not in conflict with the application but cited to understand the principle or theory underlying the invention |
|---|---|
| "A" document defining the general state of the art which is not considered to be of particular relevance | |
| "D" document cited by the applicant in the international application | "X" document of particular relevance; the claimed invention cannot be considered novel or cannot be considered to involve an inventive step when the document is taken alone |
| "E" earlier application or patent but published on or after the international filing date | |
| "L" document which may throw doubts on priority claim(s) or which is cited to establish the publication date of another citation or other special reason (as specified) | "Y" document of particular relevance; the claimed invention cannot be considered to involve an inventive step when the document is combined with one or more other such documents, such combination being obvious to a person skilled in the art |
| "O" document referring to an oral disclosure, use, exhibition or other means | |
| "P" document published prior to the international filing date but later than the priority date claimed | "&" document member of the same patent family |

---

| Date of the actual completion of the international search | Date of mailing of the international search report |
|---|---|
| **11 October 2024** | **22 October 2024** |

| Name and mailing address of the ISA/JP | Authorized officer |
|---|---|
| **Japan Patent Office (ISA/JP)**<br>**3-4-3 Kasumigaseki, Chiyoda-ku, Tokyo 100-8915**<br>**Japan** | |
| | Telephone No. |

Form PCT/ISA/210 (second sheet) (July 2022)

**INTERNATIONAL SEARCH REPORT**
Information on patent family members

International application No.

**PCT/JP2024/027815**

| Patent document cited in search report | | | Publication date (day/month/year) | Patent family member(s) | | | Publication date (day/month/year) |
|---|---|---|---|---|---|---|---|
| JP | 2003-246039 | A | 02 September 2003 | (Family: none) | | | |
| WO | 2009/145260 | A1 | 03 December 2009 | US | 2011/0116853 | A1 | |
| | | | | paragraphs [0076]-[0126], fig. 1-8 | | | |
| | | | | EP | 2286998 | A1 | |
| | | | | CN | 102317076 | A | |
| JP | 2003-237016 | A | 26 August 2003 | (Family: none) | | | |
| JP | 2008-213484 | A | 18 September 2008 | US | 2010/0002246 | A1 | |
| | | | | entire text, all drawings | | | |
| | | | | WO | 2008/007746 | A1 | |
| | | | | EP | 2039512 | A1 | |
| | | | | JP | 2008-247044 | A | |
| JP | 2016-49768 | A | 11 April 2016 | WO | 2016/031632 | A1 | |
| | | | | entire text, all drawings | | | |

Form PCT/ISA/210 (patent family annex) (July 2022)

**REFERENCES CITED IN THE DESCRIPTION**

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- JP 2016049768 A
- US 11575806 B2